# EUROPEAN PATENT APPLICATION

(11) **EP 2 065 933 A2**
(43) Date of publication of application: **03.06.2009**
(21) Application number: 08169492.9
(22) Date of filing: 20.11.2008
(51) Int. Cl.: H01L 23/367, H01L 23/373, H01L 23/473

(54) **Heat dissipation apparatus**

(30) Priority: 21.11.2007 JP 2007302176
(71) Applicant: Kabushiki Kaisha Toyota Jidoshokki, Kariya-shi, Aichi 448-8671 (JP); Showa Denko K.K., Tokyo 105-8518 (JP)
(72) Inventor: Mori, Shogo, Kariya-shi Aichi 448-8671 (JP); Yamauchi, Shinobu, Oyama-shi Tochigi 323-8678 (JP); Tamura, Shinobu, Oyama-shi Tochigi 323-8678 (JP)
(74) Representative: TBK-Patent

(57) **Abstract**

A heat dissipation apparatus including an insulation substrate, a heat sink, and a stress reduction member. The insulation substrate includes a first surface serving as a heated body receiving surface and a second surface opposite to the first surface. The heat sink is thermally coupled to the second surface of the insulation substrate. The heat sink, which includes an upper case and a lower case, serves as a liquid cooling device including a cooling passage. The stress reduction member is arranged between the insulation substrate and the upper case. The stress reduction member includes stress absorption hollows. The upper case includes a first portion that contacts the stress reduction member and a second portion defined by the remaining part of the upper case. The first portion has a thickness that is less than that of the second portion.

## Description

### BACKGROUND OF THE INVENTION

The present invention relates to a heat dissipation apparatus.

Japanese Laid-Open Patent Publication No. 2001-148451 describes an example of a heat dissipation apparatus for a power module that includes a semiconductor device such as an insulated gate bipolar transistor (IGBT). The heat dissipation apparatus described in the above publication includes a buffer layer arranged between a power module insulation substrate and a heat dissipation plate, which forms a heat sink. The buffer layer has a surface area, which is one to three times greater than that of the insulation substrate. The buffer layer is adhered to the insulation substrate and the heat dissipation plate. A water-cooled sink is arranged below the heat dissipation plate. The buffer layer has a thermal expansion coefficient which is between that of the insulation substrate and that of the heat sink. The buffer layer absorbs the difference in the level of thermal deformation between the insulation substrate and the heat sink. This decreases internal stress that is produced in the insulation substrate.

In a heat dissipation apparatus for a power module including a semiconductor device that generates a large amount of heat, it is required that the function for reducing stress, which is produced when a heated body generates heat, be improved without lowering the cooling efficiency.

### SUMMARY OF THE INVENTION

The present invention provides a heat dissipation apparatus having an improved function for reducing thermal stress without lowering the cooling efficiency.

One aspect of the present invention is a heat dissipation apparatus provided with an insulation substrate including a first surface serving as a heated body receiving surface and a second surface opposite to the first surface. A metal circuit layer is formed on the first surface, and a metal layer is formed on the second surface. A heat sink is thermally coupled to the second surface of the insulation substrate. The heat sink includes an upper case and a lower case and serves as a liquid cooling device including a cooling passage. A stress reduction member is formed from a high thermal conductance material and arranged between the metal layer of the insulation substrate and the upper case. The stress reduction member includes a stress absorption hollow and is metal-bonded to the insulation substrate and the heat sink. The upper case includes a first portion that contacts the stress reduction member and a second portion defined by the remaining part of the upper case. The first portion and the second portion each have a thickness in which the thickness of the first portion is less than the thickness of the second portion.

Other aspects and advantages of the present invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1 is a longitudinal cross-sectional view showing a preferred embodiment of a heat dissipation apparatus according to the present invention;
Fig. 2 is a longitudinal cross-sectional view showing a further embodiment of a heat dissipation apparatus according to the present invention;
Figs. 3 is a longitudinal cross-sectional view showing another embodiment of a heat dissipation apparatus according to the present invention; and
Fig. 4 is a longitudinal cross-sectional view showing still another embodiment of a heat dissipation apparatus according to the present invention.

### DETAILED DESCRIPTION OF THE PREFERRED EMBODIMENTS

A preferred embodiment of a heat dissipation apparatus for a power module installed in a vehicle according to the present invention will now be discussed. Hereafter, the term "aluminum" includes aluminum alloys in addition to pure aluminum.

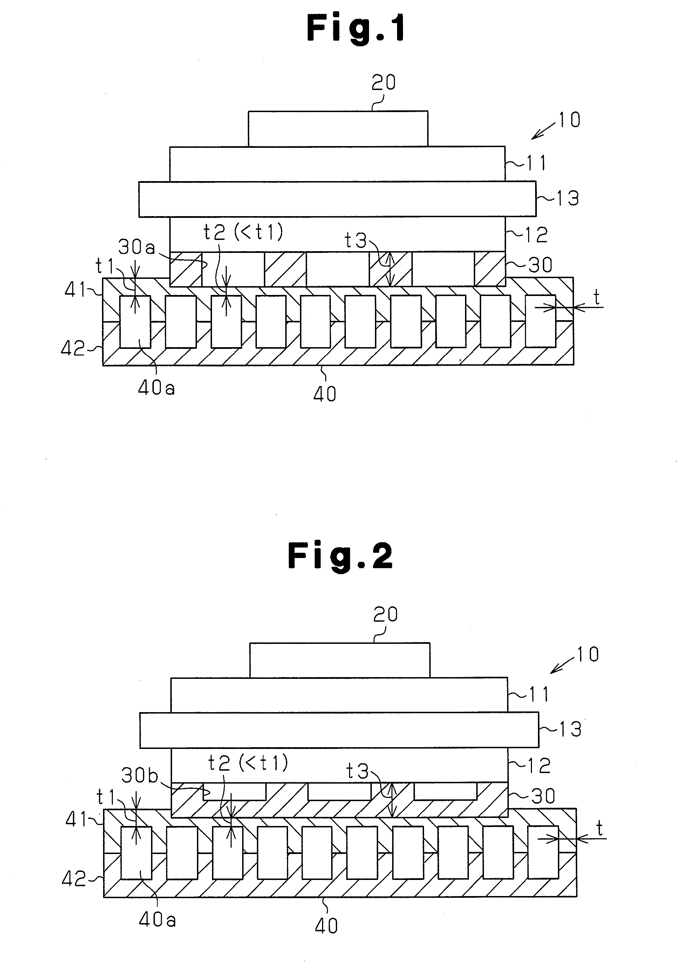

As shown in Fig. 1, the heat dissipation apparatus includes an insulation substrate 10 and a heat sink 40. The insulation substrate 10 includes a first surface (upper surface), which serves as a heated body receiving surface, and a second surface opposite to the first surface. A stress reduction member 30 is arranged between the insulation substrate 10 and the heat sink 40. The stress reduction member 30 is metal-bonded to the insulation substrate 10 and the heat sink 40. The heat sink 40 and the insulation substrate 10 are thermally coupled to each other.

The insulation substrate 10 includes an insulation ceramic substrate 13, a metal circuit layer 11, and a metal layer 12. The metal circuit layer 11 is formed on a first surface (heated body receiving surface) of the ceramic substrate 13. The metal layer 12 is formed from aluminum on a second surface of the ceramic substrate 13. The ceramic substrate 13 is formed from, for example, aluminum nitride, alumina, silicon nitride, or the like.

A semiconductor device 20 (semiconductor chip), which serves as a heated body, is soldered and bonded to the heated body receiving surface of the insulation substrate 10. An IGBT, MOSFET, diode, or the like may be used as the semiconductor device 20.

The heat sink 40 includes an upper case 41 and a lower case 42. The upper case 41 and lower case 42 are metal-bonded through brazing or the like in a state in which they are stacked together. Cooling fins or the like are arranged in the heat sink 40 to form a coolant passage 40a, which extends through the heat sink 40 so as to meander in a manner that parts of the coolant passage 40a are parallel to one another. Coolant flows through the coolant passage 40a to cool the heated body. In this manner, the heat sink 40 functions as a liquid type cooling device that includes the coolant passage 40a, which serves as a cooling passage. The coolant passage 40a includes an inlet and an outlet, which are connectable to a coolant circuit arranged in the vehicle. The cooling capacity of the heat sink 40 is set so that when the semiconductor device 20 is driven and heated, the heat generated by the semiconductor device 20 is transferred to the heat sink 40 through the insulation substrate 10 and the stress reduction member 30 and smoothly dissipated. The upper case 41 of the heat sink 40 is formed from aluminum. In the preferred embodiment, the upper case 41 and lower case 42 are both formed from aluminum.

The stress reduction member 30 is arranged between the metal layer 12 of the insulation substrate 10 and the heat sink 40. The stress reduction member 30 is metal-bonded to the insulation substrate 10 and the heat sink 40. More specifically, the insulation substrate 10, the stress reduction member 30, and the upper case 41 are brazed and bonded together. The stress reduction member 30, which is formed from a material having high thermal conductance, includes stress absorption hollows formed by a plurality of bores 30a. More specifically, the stress reduction member 30 is formed by an aluminum plate through which the bores 30a extend.

The upper case 41 of the heat sink 40 has a thickness t, which will now be discussed.

The surface of the heat sink 40 (i.e., upper case 41) facing toward the stress reduction member 30 has an area that is greater than that of the surface of the stress reduction member 30 facing toward the heat sink 40. The upper case 41 includes a first portion, which is in contact with the stress reduction member 30, and a second portion, which is defined by the remaining part of the upper case 41 other than the first portion. The first portion, which is in contact with the stress reduction member 30, includes the portion corresponding to the bores 30a of the stress reduction member 30. The first portion is the region of the upper case 41 that is inward from the contour of the stress reduction member 30 as viewed from the thickness direction of the heat dissipation apparatus. The second portion is the region of the upper case 41 that is outward from the contour of the stress reduction member 30 as viewed from the thickness direction of the heat dissipation apparatus. The second portion has a thickness t1, and the first portion has a thickness t2, which is less than the thickness t1 of the second portion.

More specifically, in the upper case 41, the thickness t1 of the second portion is 1 mm, and the thickness t2 of the first portion is 0.5 mm. Further, the stress reduction member 30 has a thickness t3 of 1 mm.

The surface of the upper case 41 facing toward the stress reduction member 30 is recessed at the first portion from the second portion. The recessed portion receives the stress reduction member 30.

The operation of the heat dissipation apparatus will now be discussed.

The heat dissipation apparatus is installed in a hybrid vehicle or the like. The heat sink 40 is connected to a coolant circuit (not shown) by pipes. A pump and radiator are arranged in the coolant circuit. The radiator includes a fan, which is rotated by a motor, and efficiently radiates heat.

When the semiconductor device 20 is driven on the heat dissipation apparatus, the semiconductor device 20 generates heat. The heat generated by the semiconductor device 20 is transferred to the heat sink 40 through the insulation substrate 10 and the stress reduction member 30 so that heat exchange occurs with the coolant flowing through the heat sink 40. This releases the heat from the heat dissipation apparatus. That is, the heat transferred to the heat sink 40 is further transferred and released to the coolant that flows through the coolant passage 40a. The heat sink 40 is forcibly cooled by the coolant flowing through the coolant passage 40a. Thus, the temperature gradient increases in the heat transfer route extending from the semiconductor device 20 to the heat sink 40, and the heat generated by the semiconductor device 20 is efficiently dissipated through the insulation substrate 10 and the stress reduction member 30.

The stress reduction member 30, which includes the stress absorption hollows defined by the plurality of bores 30a, reduces the thermal stress that is produced when the semiconductor device 20 generates heat. In the upper case 41, the thickness t2 of the first portion, which is less than the thickness t1 of the second portion, lowers the rigidity of the upper case 41 so that the upper case 41 also reduces the thermal stress. That is, the water-cooled heat sink 40 also reduces the thermal stress. Further, in the upper case 41, the thickness t2 of the first portion is less than the thickness t1 of the second portion. This shortens the distance between the semiconductor device 20 and the coolant passage 40a and improves the cooling efficiency.

The preferred embodiment has the advantages described below.
(1) The stress reduction member 30, which is formed from a high thermal conductance material and includes the stress absorption hollows (bores 30a), is arranged between the metal layer 12 of the insulation substrate 10 and the heat sink 40, which is a liquid cooling device. Further, the stress reduction member 30 is metal-bonded to the insulation substrate 10 and the heat sink 40. In the upper case 41, the thickness t2 of the first portion is less than the thickness t1 of the second portion. Therefore, the function of the heat dissipation apparatus for reducing thermal stress is improved without lowering the cooling efficiency.
(2) The metal layer 12 and the upper case 41 are formed from aluminum, and the stress reduction member 30 is formed from an aluminum plate including the bores 30a. Thus, the aluminums may be brazed (metal-bonded) together. Further, the bores 30a of the stress reduction member 30 serve to form stress absorption hollows.

It should be apparent to those skilled in the art that the present invention may be embodied in many other specific forms without departing from the spirit or scope of the invention. Particularly, it should be understood that the present invention may be embodied in the following forms.

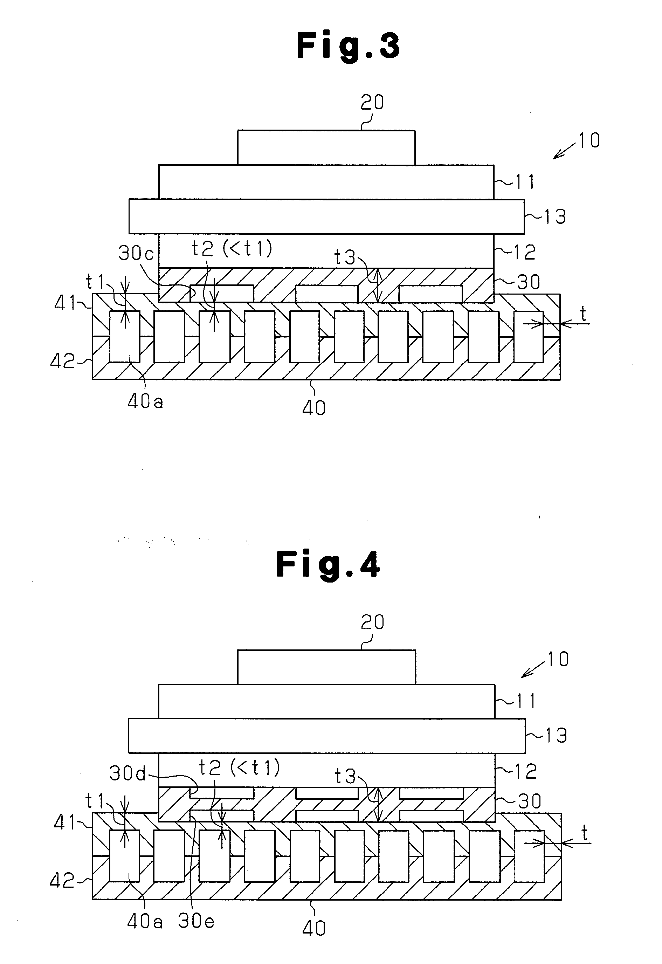

As shown in Fig. 2, the stress reduction member 30 may be an aluminum plate having a surface facing towards the insulation substrate 10 that includes a plurality of recesses 30b. Alternatively, as shown in Fig. 3, the stress reduction member 30 may be an aluminum plate having a surface facing towards the heat sink 40 that includes a plurality of recesses 30c. As another option, referring to Fig. 4, the stress reduction member 30 may be an aluminum plate having a surface facing towards the insulation substrate 10 that includes a plurality of recesses 30d and a surface facing towards the heat sink 40 that includes a plurality of recesses 30e. In this manner, the metal layer 12 and the upper case 41 is formed from aluminum, and the stress reduction member 30 is formed from an aluminum plate including recesses in at least either one of the surface facing toward the insulation substrate 10 and the surface facing toward the heat sink 40. In such a case, the aluminums may be brazed (metal-bonded) together. Further, the stress absorption hollows may be formed by the plurality of hollows.

Coolant flows through the heat sink 40, which serves as a liquid cooling device. Instead, other cooling liquids such as alcohol may flow through the heat sink 40.

The present examples and embodiments are to be considered as illustrative and not restrictive, and the invention is not to be limited to the details given herein, but may be modified within the scope and equivalence of the appended claims.

A heat dissipation apparatus including an insulation substrate, a heat sink, and a stress reduction member. The insulation substrate includes a first surface serving as a heated body receiving surface and a second surface opposite to the first surface. The heat sink is thermally coupled to the second surface of the insulation substrate. The heat sink, which includes an upper case and a lower case, serves as a liquid cooling device including a cooling passage. The stress reduction member is arranged between the insulation substrate and the upper case. The stress reduction member includes stress absorption hollows. The upper case includes a first portion that contacts the stress reduction member and a second portion defined by the remaining part of the upper case. The first portion has a thickness that is less than that of the second portion.

## Claims

1. A heat dissipation apparatus comprising:
an insulation substrate (10) including a first surface serving as a heated body receiving surface and a second surface opposite to the first surface, with a metal circuit layer (11) formed on the first surface, and a metal layer (12) formed on the second surface;
a heat sink (40) thermally coupled to the second surface of the insulation substrate (10), with the heat sink (40) including an upper case (41) and a lower case (42) and serving as a liquid cooling device including a cooling passage (40a); and
a stress reduction member (30) formed from a high thermal conductance material and arranged between the metal layer (12) of the insulation substrate (10) and the upper case (41), with the stress reduction member (30) including a stress absorption hollow (30a, 30b, 30c, 30d, 30e) and being metal-bonded to the insulation substrate (10) and the heat sink (40);
**characterized in that** the upper case (41) includes a first portion that contacts the stress reduction member (30) and a second portion defined by the remaining part of the upper case (41), with the first portion and the second portion each having a thickness in which the thickness (t2) of the first portion is less than the thickness (t1) of the second portion.

2. The heat dissipation apparatus according to claim 1, **characterized in that**:
the metal layer (12) and the upper case (41) are formed from aluminum; and
the stress reduction member (30) is formed from an aluminum plate including a plurality of bores (30a).

3. The heat dissipation apparatus according to claim 1, **characterized in that**:
the metal layer (12) and the upper case (41) are formed from aluminum; and
the stress reduction member (30) is formed from an aluminum plate including a plurality of recesses (30b, 30c, 30d, 30e) in at least either one of a surface facing toward the insulation substrate (10) and a surface facing toward the heat sink (40).

4. The heat dissipation apparatus according to any one of claims 1 to 3, **characterized in that** the upper case (41) has a surface facing toward the stress reduction member (30) that is recessed at a portion corresponding to the first portion from the portion corresponding to the second portion.
